(19) **Europäisches Patentamt / European Patent Office / Office européen des brevets**

(11) **EP 4 636 414 A1**

(12) # EUROPEAN PATENT APPLICATION

(43) Date of publication:
**22.10.2025 Bulletin 2025/43**

(21) Application number: **24170236.4**

(22) Date of filing: **15.04.2024**

(51) International Patent Classification (IPC):
**G01R 31/08** (2020.01)

(52) Cooperative Patent Classification (CPC):
**G01R 31/085**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Hitachi Energy Ltd
8050 Zürich (CH)**

(72) Inventor: **NAIDU, Obbalareddi Demudu
560087 Bangalore, Karnataka (IN)**

(74) Representative: **Vossius & Partner
Patentanwälte Rechtsanwälte mbB
Siebertstrasse 3
81675 München (DE)**

(54) **HYBRID FAULT LOCATION METHODOLOGY FOR POWER TRANSMISSION LINES**

(57) The present invention provides method, a device and a computer-readable medium for determining a fault location in a power transmission line. According to the invention, a phasor-based fault location and a traveling wave fault location are determined. The fault location is determined based on the determined phasor-based fault location and the determined traveling wave fault location. Preferably, when the determined traveling wave fault location is consistent with the determined phasor-based fault location, the determined traveling wave fault location is used as the fault location, while otherwise, the determined phasor-based fault location is used.

Fig. 1:

**Description**

The present disclosure relates to a method, a device, and a computer-readable medium for determining a fault location in a power transmission line. In particular, the disclosure provides a hybrid method using phasor-based fault location and traveling wave fault location for determining the fault location.

Transmission lines are the backbone for transportation of electrical energy from sources of generation to load centers. Power transmission lines experience faults that are caused by nature such as storms, lightning, snow, rain, insulation breakdown and short circuit faults caused by birds, tree branches and other external objects. Restoration of power supply after permanent faults can be done only after the maintenance team finishes the repair of the damage caused by the fault. For this purpose, the fault location has to be known, otherwise the whole line has to be inspected to find the fault point. This task becomes even more tedious and time consuming, if high voltage transmission lines, running up to hundreds of kilometers are considered. Underground lines and cables have to be uncovered from under the ground, requiring more manpower and machines, and in populated areas, roads and passageways have to be blocked to perform the inspection and repair. Thus, it is important that the location of a fault is either known or can be calculated with a good accuracy. This allows saving of both money and time for the inspection and repairwork, and aids towards better service by utilities and improve the reliability. In other words, quick identification of fault location improves the reliability, availability and saves the revenue loss for the utilities.

Accurate fault locator thus can help end users (Electric Utilities) to

- fix the network faults efficiently and restore power transmission lines quickly,
- improve overall network availability and reliability,
- reduce repair and restoration cost for utilities and consequently, reduced power bills for end customers,
- avoid high-cost patrolling methods like helicopter and drone search, and
- avoid unsafe crew patrolling, especially in difficult geographical terrains thereby improving safety of the field staff.

Impedance-based fault locating methods require that the fundamental voltage and current quantities to be accurately measured. These impedance-based methods are reliable but less accurate since the fault location calculation depends on the accuracy of the phasors. The phasor calculation during fault due to transients may not be accurate. Therefore, the impedance-based fault location accuracy is practically 1% of the line length. With recent improvements in data acquisition and signal processing technology, traveling-wave fault locators are becoming more popular where higher accuracy is important. Traveling wave technology can locate the fault within two tower span distance (i.e., 300m). These methods are more accurate, but less reliable and their accuracy depends on the accuracy of the wave speed, correct capturing of the traveling wave arrival times and other tuning parameters. Most of the time, the capturing of the correct traveling wave arrival times is difficult due to multiple reflections from the other impedance discontinuity points in the substation and power networks. Therefore, the is a need for reliable, accurate and setting-free fault location for power transmission lines.

A two end synchronous measurement-based traveling wave fault location method has been disclosed in US 8 655 609 B2 and has been implemented and commercial used. The accuracy of available methods is reported as two tower distance (280 to 330 meters). However, the accuracy of traveling wave-based methods depends on the line parameters (such as inductance and capacitance per unit length). These line parameters are never correct and depend on many practical conditions. This may cast doubt on the stated accuracy.

A setting free fault location method has been reported by F. V. Lopes, "Settings-Free Traveling-Wave-Based Earth Fault Location Using Unsynchronized Two- Terminal Data," in IEEE Transactions on Power Delivery, vol. 31, no. 5, pp. 2296-2298, Oct. 2016. This method requires both aerial and ground mode signals. The ground mode signals are highly attenuated and non-reliable and available only for earth faults. That is, this method is suitable only for earth faults.

Parameter adjustment by conducting experiments is proposed in US 8 990 036 B1. This method requires to create fault at known distance. This may require additional experiments and engineering effort to implement this in the field.

Fault location without using the wave speed is proposed in V. Lopes, K. M. Dantas, K. M. Silva and F. B. Costa, "Accurate Two-Terminal Transmission Line Fault Location Using Traveling Waves," in IEEE Transactions on Power Delivery, vol. 33, no. 2, pp. 873-880, April 2018 using two traveling wave arrival times (incident and reflected from fault point) measured at both ends of the line. This method finds limited performance for faults close to the terminals of the line due to the requirement of two traveling wave arrival times of incident and reflection waves from the fault point, at both ends. It may not work in certain situations like faults that are located closer to the line ends. Moreover, fault location without wave speed is proposed in O. D. Naidu and A. K. Pradhan, "Model Free Traveling Wave Based Fault Location Method for Series Compensated Transmission Line," in IEEE Access, vol. 8, pp. 193128-193137, 2020 using two arrival times measured at both ends of the line. It requires only the first two traveling wave arrival times recorded at both ends. This is a promising method, but it requires two arrival times from both ends, and a second arrival time may not be captured in special situations.

Therefore, there is a need for a setting-free fault location methodology using only first traveling wave arrival time which is more reliable and robust for the field deployments, in particular, due to the limitations discussed above for existing methods in the prior art.

The present disclosure provides a reliable and robust setting-free fault location methodology using the phasor and traveling wave principles. The hybrid methodology of the present disclosure exploits the advantages of both principles to achieve more reliable and accurate fault location for transmission lines without any engineering settings.

Accordingly, the present invention provides a method, device and computer-readably medium for determining a fault location d in a power transmission line, as defined by the appended independent claims.

Specifically, the present disclosure requires determining a phasor-based fault location $d_{PHFL}$, and a traveling wave fault location $d_{TWFL}$. The fault location d is then determined based on the determined phasor-based fault location $d_{PHFL}$ and the determined traveling wave fault location $d_{TWFL}$. For example, the fault location may be determined by determining whether the determined phasor-based fault location $d_{PHFL}$ and the determined traveling wave fault location $d_{TWFL}$ are compatible with each other. In this case, the more accurate value of $D_{TWFL}$ is used as the result of the fault location determination. Otherwise $d_{PHFL}$ is used. However, also alternative ways of combining both measurements can be used, such as a different weighting of the two results.

The decision whether $D_{TWFL}$ is consistent with the $d_{PHFL}$ may be affirmed when $D_{TWFL}$ falls within an error interval e around $d_{PHFL}$, that is, if $d_{PHFL} - e \leq D_{TWFL} \leq d_{FHFL} + e$. The error e to be used may be 5% of $d_{PHFL}$, preferably 2% of $d_{PHFL}$ and more preferably 1% of $d_{PHFL}$.

The disclosure may further include determining pre-fault voltage and current of the power transmission line. The determined pre-fault voltage and current may in particular be used to determine line parameters $\gamma$, Zc and a wave speed.

The phasor-based fault location $d_{PHFL}$ may be determined using the determined line parameters. The traveling wave fault location $D_{TWFL}$ may be determined using traveling wave arrival times and the determined wave speed. In particular only a first traveling wave arrival time may be used for determining the traveling wave fault location $d_{TWFL}$.

In a case where no travelling wave arrival times are available, the fault location may be determined only using the phasor-based fault location $d_{PHFL}$.

The present disclosure further relates to a corresponding device and a computer-readably medium for determining a fault location d in a power transmission line.

The present disclosure gives a reliable and robust fault location solution for transmission lines without the need of any settings, thereby reducing the engineering effort. The reliable and robust setting-free fault location methodology using the phasor and traveling wave principles. The proposed hybrid methodology exploits the advantages of both principles to achieve more accurate and reliable fault location for transmission lines without any engineering settings. The proposed method accurately estimates wave speed using the pre-fault data, is non-iterative and computationally simple to be implemented on a real-time IED CPU.

The present disclosure will be described in more detail in the following description with reference to figures, wherein

Fig. 1          shows a two-terminal system with GPS synchronized IED's at both ends,

Fig. 2          shows (a) a pre-fault long line equivalent model and (b) a positive sequence during fault model,

Fig. 3          shows a Bewley lattice diagram for a fault d distance from bus M,

Fig. 4          shows (a) a basic concept for determining consistency of the fault determining methods and (b) a flow chart for depicting steps of the method of the present disclosure,

Fig. 5 and 6    exemplarily show voltage and current waveforms of local and remote ends of a transmission line.

In the following, steps of the method according to the disclosure are explained in more detail referring to mathematical derivations. As a first step, line parameters and wave speed are determined using the pre-fault voltage and current measurements.

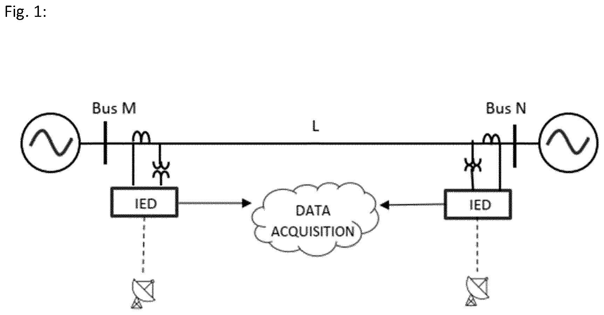

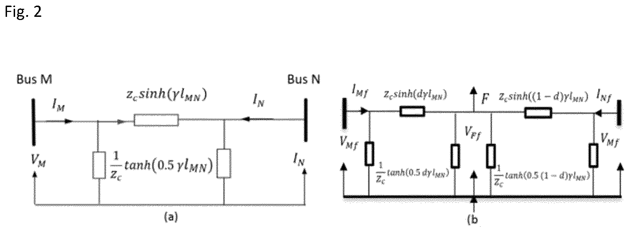

A transmission line is shown in Fig. 1, and its corresponding pre-fault network is shown in Fig. 2. From the pre-fault long line equivalent model shown in Fig. 2a, the long line equivalent ABCD model can be written as in (1):

$$\begin{bmatrix} V_M \\ I_M \end{bmatrix} = \begin{bmatrix} \cosh(\gamma l_{MN}) & Z_c \sinh(\gamma l_{MN}) \\ \frac{1}{Z_C} \sinh(\gamma l_{MN}) & \cosh(\gamma l_{MN}) \end{bmatrix} \begin{bmatrix} V_R \\ -I_R \end{bmatrix} \qquad (1)$$

Where, $V_M$, $I_M$, $V_R$ and $I_R$ are the positive sequence local and remote terminal voltages and currents respectively; $\gamma$ and $Z_c$ are the transmission line propagation constant and characteristic impedance respectively. The voltage and current relationships can be obtained from equation (1) as (2) and (3) respectively.

$$V_M = V_N \cosh(\gamma l_{MN}) - I_N Z_c \sinh(\gamma l_{MN}) \tag{2}$$

$$I_M = \frac{V_N}{Z_C} \sinh(\gamma l_{MN}) - I_N \cosh(\gamma l_{MN}) \tag{3}$$

From (2) and (3), the line propagation constant ($Z_c$) is obtained as in (4) and (5) respectively.

$$Z_c = \frac{V_N \cosh(\gamma l_{MN}) - V_M}{I_N \sinh(\gamma l_{MN})} \tag{4};$$

$$Z_C = \frac{V_N \sinh(\gamma l_{MN})}{I_M + I_N \cosh(\gamma l_{MN})} \tag{5}$$

Equating (4) and (5) and simplifying the relationships, we obtain a formulation as in (6).

$$(V_N I_M - V_M I_N) \cosh(\gamma l_{MN}) - V_M I_M + V_N I_N \cosh^2 \gamma l_{MN} = V_N I_N \sinh^2(\gamma l_{MN}) \tag{6}$$

By rearranging and simplifying (6), a formulation as in (7) is obtained:

$$(V_N I_M - V_M I_N) \cosh(\gamma l_{MN}) = V_M I_M - V_N I_N (\cosh^2 \gamma l_{MN} - \sinh^2(\gamma l_{MN})) \tag{7}$$

The equation (7) can be written as (8) by substituting the identity law (i.e., $\cosh^2 \gamma l_{MN} - \sinh^2 \gamma l_{MN} = 1$):

$$(V_N I_M - V_M I_N) \cosh(\gamma l_{MN}) = V_M I_M - V_N I_N(1) \tag{8}$$

The line propagation constant ($\gamma$) can be obtained as in (9):

$$\gamma = \frac{1}{l} \cosh \left( \frac{V_N I_M}{V_N I_M - V_M I_N} - \frac{V_N I_N}{V_N I_M - V_M I_N} \right) \tag{9}$$

The line characteristic impedance can be obtained by substituting (9) in (5) as in (10).

$$Z_C = \frac{V_N \sinh\left( \left(\frac{1}{l}\cosh\left(\frac{V_N I_M}{V_N I_M - V_M I_N} - \frac{V_N I_N}{V_N I_M - V_M I_N}\right)\right) l_{MN} \right)}{I_M + I_N \cosh\left( \left(\frac{1}{l}\cosh\left(\frac{V_N I_M}{V_N I_M - V_M I_N} - \frac{V_N I_N}{V_N I_M - V_M I_N}\right)\right) \right)} \tag{10}$$

The wave speed of the transmission line is obtained as in (11):

$$V = \frac{2*pi*f}{|\gamma|} \tag{11}$$

Where, V is the wave speed of the line, f is the frequency of the line and y is the line propagation constant.
As a next step, the phasor-based fault location is estimated using the determined line parameters and during fault phasors.
From Fig. 2b, the fault location is obtained as in (12) by equating the fault point voltage calculated from both line terminals.

$$d_{PFL} = \frac{1}{\gamma l_{MN}} \tanh^{-1} \left( \frac{K_1}{K_2} \right) \tag{12}$$

where

$$K_1 = V_N^1 \cosh(\gamma l_{MN}) + (I_N^1 Z_C^1)(\sinh(\gamma l_{MN}) - V_M^1;$$

$$K_2 = V_N^1 \sinh(\gamma l_{MN}) - (I_N^1 Z_C^1)(\cosh(\gamma l_{MN}) - Z_C^1 I_M^1$$

Where $d_{PFL}$ is the phasor-based fault location.

Then, the fault location using the traveling wave arrival times can be determined as follows.

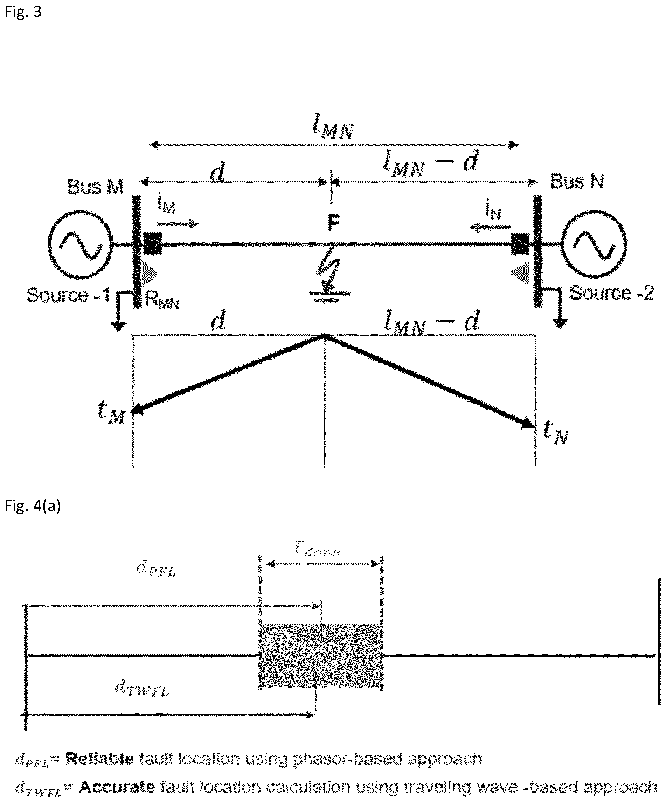

Considering a fault at 'd' from the Bus M as shown in Fig. 3, corresponding traveling wave arrival times are marked in the Bewley lattice diagram as shown in the figure. From the lattice diagram, the following relationship can be taken:

$$t_{M1} = t_{0M} + \frac{d_{TWFL}}{V} \qquad ; t_{N1} = t_{0N} + \left(l_{MN} - \frac{d_{TWFL}}{V}\right) \qquad (13)$$

where $l_{MN}$ is the length of the transmission line, V is the wave speed of the transmission line, $d_{TWFL}$ is the traveling wave based fault location from terminal M, $t_{M1}$ and $t_{N1}$ are the first traveling wave arrival times recorded at terminals M and N, respectively, and $t_{0M}$ and $t_{0N}$ are the fault inception times recorded by locators at terminals M and N, respectively.

The fault location can be obtained from (13) as in (14):

$$d_{TWFL} = \frac{1}{2}(l_{MN} - (t_N - t_M)V) \qquad (14)$$

The wave speed obtained using (11) can be used to calculate the fault location using (14). These two-fault locator (phasor and traveling wave) values can be combined to get a reliable accurate fault locator (Hybrid fault locator). In this approach, the line parameters and wave speed are computed using the pre-fault data. Then, the two fault location values are calculated using phasor and traveling wave information. As a second step, the shortest fault zone can be defined by using the phasor-based fault location information. Finally, the traveling wave-based fault locator is determined as the final value if the value settles within the fault zone or otherwise, the phasor-based fault locator is determined as the final value. This approach eliminates the settings, and it is more reliable and accurate as it makes use of the advantages of the traveling wave and phasor-based technologies.

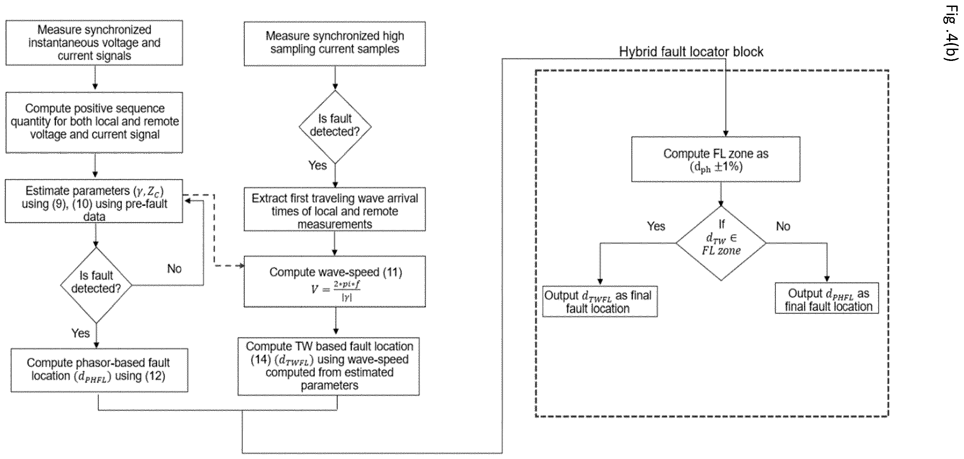

The basic concept and complete flow chart to depict the proposed method is provided in Fig.4. As shown in Fig. 4(b), the method of the disclosure described in two branches, relating to the phasor-based fault location and traveling wave-based fault location, respectively. However, as described in the following, the two branches interact in some regard. For phasor-based fault location, synchronized instantaneous voltage and current signals are determined and a positive sequence quantity for both local and remote voltage and current signal can be calculated. Using pre-fault data, parameters y and $Z_c$ can be estimated, as described in detail above. If a fault is detected the phasor-based fault location is determined.

For traveling wave-based fault location, synchronized high sampling current samples are measured. If a fault is detected, the first traveling wave arrival times of local and remote measurements are extracted. The wave-speed necessary for determining the traveling-wave fault location can be computed from the parameters obtained in the phasor-based fault location branch. From these parameters, the traveling-wave fault based location is determined.

By combining the two fault location values, the hybrid fault location can be used as shown in Fig. 4(b). To this end, a fault location zone is determined, based on the phasor-based fault location and taking into account its error. If the traveling wave-based fault location falls into the error range, the traveling wave-based fault location is selected as final fault location. Otherwise, if the determined traveling wave-based fault location is outside this range, the determined phasor-based fault location is selected as final fault location.

The concept of the present disclosure is further explained with numerical examples in the following.

Example 1

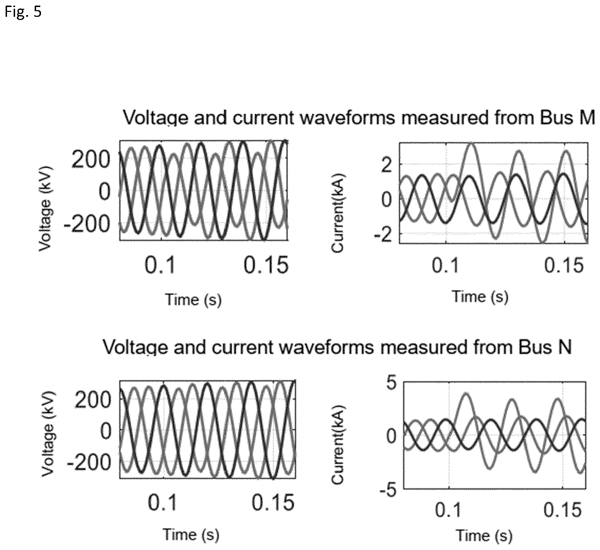

Exemplarily, a two terminal 400kV, 50Hz system and a frequency dependent model for a transmission line of length 300 km are considered. For the present example, a Ag fault at 150km from bus M as shown in Fig. 3 is considered. The fault resistance and fault inception angle are considered to be 50Ω and 60 degrees, respectively. The voltage and current signals are shown in Fig. 5. The details of each step of the disclosure are explained as follows.

Fig. 5 depicts the acquired local and remote end voltage and current waveforms representing the synchronized IEDs at Bus M and Bus N, respectively. The characteristic impedance and propagation constant can be obtained using equations (9) and (10) above. Thereby, the following values for the parameters of the transmission line can be determined using pre-fault data:

| Relay | Actual Parameters | | Estimated Parameters | |
|---|---|---|---|---|
| | $Z_{cLact}$ (Ω/m) | γLact(*10⁻⁶) (Ω/m) | $Z_{cLest}$ (Ω/m) | $γ_{Lest}$(*10⁻⁶) (Ω/m) |
| Bus M | 181.9-0.13i | 0.019+1.089i | 181.8+0.59i | 0.039+1.09i |

In addition, the wave speed can be determined using (11). This leads to the following result:

$$v = \frac{2 * pi * 50}{|(0.039 + 1.09i) * 10^{-6}|} = 2.88 * 10^5 km/s$$

The fault location is determined using post fault phasors using equation (12):

| Relay | Actual fault location (km) | Calculated fault location (km) | Error (m) | Error (%) |
|---|---|---|---|---|
| Bus M | 150 | 149.563 | 437 | 0.1453 |

From these results, the fault zone can be determined using the calculated phasor-based fault location information. In particular, the fault zone can be defined by adding and subtracting 1% of the line length to the calculated phasor-based fault location. In this case, the fault zone is 146.56 km to 152.56 km.

Determining the traveling wave-based fault location using equation (14) with the computed wave speed (11) and first traveling wave arrival time results in:

| Relay | $t_{M1}$ | $t_{N1}$ | d | Error (m) | Error (%) |
|---|---|---|---|---|---|
| Bus M | 0.100518 | 0.100519 | 150.02 | 20 | 0.006 |

For selecting the final fault location between the phasor and traveling wave-based approaches it can be observed that in the present case, the determined traveling wave-based fault location is included into the faulted zone. Therefore, final fault location can be selected as the traveling wave-based fault location. The output is determined as 149.94 km. In this case, the traveling wave based fault location is very accurate and the error is only 20m.

Example 2

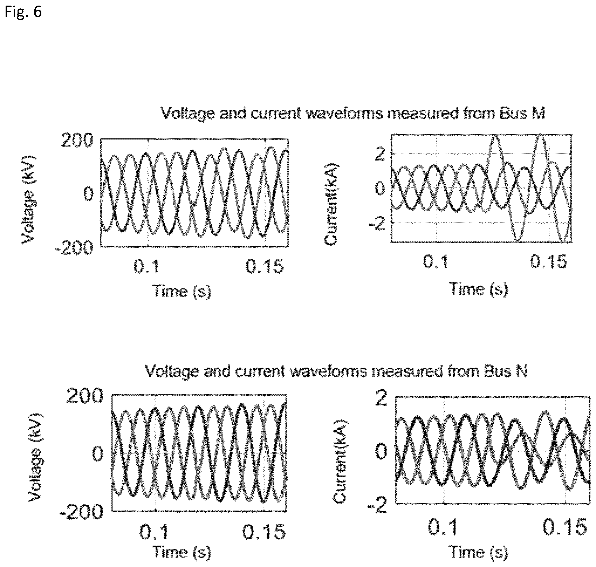

In this example, a BC-g fault at 3km from the bus M as shown Fig.3. The fault resistance and fault inception angle are considered is 20Ω and 90 degrees. The voltage and current signals are shown in Fig. 6. The details of each step of the disclosure is explained as follows.

In this example, Fig. 6 depicts the acquired local and remote end voltage and current waveforms representing the synchronized IEDs at Bus M and Bus N, respectively. The characteristic impedance and propagation constant can again be obtained using equations (9) and (10) above.

Thereby, the following values for the parameters of the transmission line can be determined using pre-fault data:

| Relay | Actual Parameters | | Estimated Parameters | |
|---|---|---|---|---|
| | $Z_{cLact}$ (Ω/m) | γLact(*10⁻⁶) (Ω/m) | $Z_{cLest}$ (Ω/m) | $γ_{Lest}$(*10⁻⁶) (Ω/m) |
| Bus M | 181.9-0.13i | 0.019+1.089i | 181.8+0.59i | 0.039+1.09i |

Similarly, the wave speed can be determined using (11). Again, this leads to the following result:

$$v = \frac{2 * pi * 50}{|(0.039 + 1.09i) * 10^{-6}|} = 2.88 * 10^5 km/s$$

In this example, the fault location determined using post fault phasors using equation (12) leads to:

6

| Relay | Actual fault location (km) | Calculated fault location (km) | Error (m) | Error (%) |
|-------|---------------------------|-------------------------------|-----------|-----------|
| Bus M | 3 | 3.475 | 475 | 0.158 |

The fault zone again is determined using the calculated phasor-based fault location information, by adding and subtracting 1% of the line length to the calculated phasor-based fault location. In this case, the fault zone is 0.475 km to 6.475 km.

Determining the traveling wave-based fault location using equation (14) with the computed wave speed (11) and first traveling wave arrival time results, however, in:

| Relay | $t_{M1}$ | $t_{N1}$ | d | Error (m) | Error (%) |
|-------|----------|----------|---|-----------|-----------|
| Bus M | 0.1006394 | 0.101504 | 24.475 | 21.475 | 7,15 |

As can be seen, the calculated traveling wave-based fault location is not located in the faulted zone. Therefore, the final fault location is selected as the phasor-based fault location. The output is determined as 3.475 km

The claimed hybrid fault location method using the phasor and traveling wave information thus is able to exploit the advantages of both technologies to provide a reliable and accurate fault location for transmission lines. This approach does not require the settings and reflected traveling waves and is able to save overall engineering costs. The present disclosure thus can greatly improve the determination of a a fault location in a power transmission line.

While various embodiments of the present disclosure have been described above, it should be understood that they have been presented by way of example only, and not by way of limitation. Likewise, the various diagrams may depict an example architectural or configuration, which are provided to enable persons of ordinary skill in the art to understand exemplary features and functions of the present disclosure. Such persons would understand, however, that the present disclosure is not restricted to the illustrated example architectures or configurations, but can be implemented using a variety of alternative architectures and configurations. Additionally, as would be understood by persons of ordinary skill in the art, one or more features of one embodiment can be combined with one or more features of another embodiment described herein. Thus, the breadth and scope of the present disclosure should not be limited by any of the above-described exemplary embodiments.

It is also understood that any reference to an element herein using a designation such as "first," "second," and so forth does not generally limit the quantity or order of those elements. Rather, these designations can be used herein as a convenient means of distinguishing between two or more elements or instances of an element. Thus, a reference to first and second elements does not mean that only two elements can be employed, or that the first element must precede the second element in some manner.

Additionally, a person having ordinary skill in the art would understand that information and signals can be represented using any of a variety of different technologies and techniques. For example, data, instructions, commands, information, signals, bits and symbols, for example, which may be referenced in the above description can be represented by voltages, currents, electromagnetic waves, magnetic fields or particles, optical fields or particles, or any combination thereof.

A skilled person would further appreciate that any of the various illustrative logical blocks, units, processors, means, circuits, methods and functions described in connection with the aspects disclosed herein can be implemented by electronic hardware (e.g., a digital implementation, an analogue implementation, or a combination of the two), firmware, various forms of program or design code incorporating instructions (which can be referred to herein, for convenience, as "software" or a "software unit"), or any combination of these techniques.

To clearly illustrate this interchangeability of hardware, firmware and software, various illustrative components, blocks, units, circuits, and steps have been described above generally in terms of their functionality. Whether such functionality is implemented as hardware, firmware or software, or a combination of these techniques, depends upon the particular application and design constraints imposed on the overall system. Skilled artisans can implement the described functionality in various ways for each particular application, but such implementation decisions do not cause a departure from the scope of the present disclosure. In accordance with various embodiments, a processor, device, component, circuit, structure, machine, unit, etc. can be configured to perform one or more of the functions described herein. The term "configured to" or "configured for" as used herein with respect to a specified operation or function refers to a processor, device, component, circuit, structure, machine, unit, etc. that is physically constructed, programmed and/or arranged to perform the specified operation or function.

Furthermore, a skilled person would understand that various illustrative methods, logical blocks, units, devices, components and circuits described herein can be implemented within or performed by an integrated circuit (IC) that can include a general purpose processor, a digital signal processor (DSP), an application specific integrated circuit (ASIC), a field programmable gate array (FPGA) or other programmable logic device, or any combination thereof. The logical blocks, units, and circuits can further include antennas and/or transceivers to communicate with various components within the network or within the device. A general purpose processor can be a microprocessor, but in the alternative, the processor can be any conventional processor, controller, or state machine. A processor can also be implemented as a combination of computing devices, e.g., a combination of a DSP and a microprocessor, a plurality of microprocessors, one or more microprocessors in conjunction with a DSP core, or any other suitable configuration to perform the functions described herein. If implemented in software, the functions can be stored as one or more instructions or code on a computer-readable medium. Thus, the steps of a method or algorithm disclosed herein can be implemented as software stored on a computer-readable medium.

Computer-readable media includes both computer storage media and communication media including any medium that can be enabled to transfer a computer program or code from one place to another. A storage media can be any available media that can be accessed by a computer. By way of example, and not limitation, such computer-readable media can include RAM, ROM, EEPROM, CD-ROM or other optical disk storage, magnetic disk storage or other magnetic storage devices, or any other medium that can be used to store desired program code in the form of instructions or data structures and that can be accessed by a computer.

Additionally, memory or other storage, as well as communication components, may be employed in embodiments of the present disclosure. It will be appreciated that, for clarity purposes, the above description has described embodiments of the present disclosure with reference to different functional units and processors. However, it will be apparent that any suitable distribution of functionality between different functional units, processing logic elements or domains may be used without detracting from the present disclosure. For example, functionality illustrated to be performed by separate processing logic elements, or controllers, may be performed by the same processing logic element, or controller. Hence, references to specific functional units are only references to a suitable means for providing the described functionality, rather than indicative of a strict logical or physical structure or organization.

Various modifications to the implementations described in this disclosure will be readily apparent to those skilled in the art, and the general principles defined herein can be applied to other implementations without departing from the scope of this disclosure. Thus, the disclosure is not intended to be limited to the implementations shown herein, but is to be accorded the widest scope consistent with the novel features and principles disclosed herein, as recited in the claims below.

**Claims**

1. Method for determining a fault location d in a power transmission line, comprising the steps of:

   (a) determining a phasor-based fault location $d_{PHFL}$;
   (b) determining a traveling wave fault location $d_{TWFL}$; and
   (c) determining a fault location d based on the determined phasor-based fault location $d_{PHFL}$ and the determined traveling wave fault location $d_{TWFL}$.

2. Method of claim 1, wherein in step (c) the fault location d is determined as follows:

   $d = D_{TWFL}$ when $D_{TWFL}$ is consistent with $d_{PHFL}$, and
   otherwise $d = d_{PHFL}$.

3. Method according to claim 2, wherein $D_{TWFL}$ is consistent with the $d_{PHFL}$ when $d_{TWFL}$ falls within an error interval e around $d_{PHFL}$, $d_{PHFL} - e \leq D_{TWFL} \leq d_{FHFL} + e$.

4. Method according to claim 3, wherein e is 5% of $d_{PHFL}$, preferably 2% of $d_{PHFL}$ and more preferably 1% of $d_{PHFL}$.

5. Method according to any one of claims 1 to 4, further comprising the step of determining pre-fault voltage and current of the power transmission line.

6. Method according to claim 5, further comprising the step of determining line parameters $\gamma$, Zc and a wave speed using the determined pre-fault voltage and current, wherein the phasor-based fault location $d_{PHFL}$ is preferably determined using the determined line parameters.

7. Method according to claim 6, wherein the traveling wave fault location $D_{TWFL}$ is determined using traveling wave arrival times and the determined wave speed.

8. Method according to claim 7, wherein only a first traveling wave arrival time is used for determining the traveling wave fault location $d_{TWFL}$,
wherein the fault location is preferably determined only using phasor-based fault location $d_{PHFL}$ when no travelling wave arrival times are available.

9. Device for determining a fault location d in a power transmission line comprising a processor configured to:

   determine a phasor-based fault location $d_{PHFL}$;
   determine a traveling wave fault location $d_{TWFL}$; and
   determine a fault location d based on the determined phasor-based fault location $d_{PHFL}$ and the determined traveling wave fault location $d_{TWFL}$.

10. Device of claim 9, wherein the processor is configured to determine the fault location d as follows:
    $d = D_{TWFL}$ when $D_{TWFL}$ is consistent with $d_{PHFL}$, and
    otherwise $d = d_{PHFL}$.

11. Device according to claim 9 or 10, wherein the processor is further configured to determine pre-fault voltage and current of the power transmission line.

12. Device according to claim 11, wherein the processor is further configured to determine line parameters $\gamma$, Zc and a wave speed using the determined pre-fault voltage and current,
wherein the processor is preferably further configured to determine the phasor-based fault location $d_{PHFL}$ using the determined line parameters.

13. Device according to claim 12, wherein the processor is further configured to determine the traveling wave fault location $D_{TWFL}$ using traveling wave arrival times and the determined wave speed.

14. Device according to claim 13, wherein the processor is further configured to determine the traveling wave fault location $D_{TWFL}$ only using a first traveling wave arrival time,
wherein the processor is further configured to preferably determine the fault location only using phasor-based fault location $d_{PHFL}$ when no travelling wave arrival times are available.

15. Computer-readable medium comprising instructions which, when executed by a computer, cause the computer to carry out the steps of the method of any one of claims 1 to 8.

Fig. 1:

Fig. 2

(a)

(b)

Fig. 3

Fig. 4(a)

$d_{PFL}$ = **Reliable** fault location using phasor-based approach

$d_{TWFL}$ = **Accurate** fault location calculation using traveling wave -based approach

Fig .4(b)

Hybrid fault locator block

Compute FL zone as ($d_{ph}$ ±1%)

If $d_{TW} \in FL\ zone$

No → Output $d_{PHFL}$ as final fault location

Yes → Output $d_{TWFL}$ as final fault location

Measure synchronized high sampling current samples

Is fault detected? — Yes → Extract first traveling wave arrival times of local and remote measurements

Compute wave-speed (11) $V = \frac{2*pi*f}{|\gamma|}$

Compute TW based fault location (14) ($d_{TWFL}$) using wave-speed computed from estimated parameters

Measure synchronized instantaneous voltage and current signals

Compute positive sequence quantity for both local and remote voltage and current signal

Estimate parameters ($\gamma, Z_c$) using (9), (10) using pre-fault data

Is fault detected? — No / Yes → Compute phasor-based fault location ($d_{PHFL}$) using (12)

Fig. 5

### Voltage and current waveforms measured from Bus M

### Voltage and current waveforms measured from Bus N

Fig. 6

Voltage and current waveforms measured from Bus M

Voltage and current waveforms measured from Bus N

| | Europäisches Patentamt European Patent Office Office européen des brevets | **EUROPEAN SEARCH REPORT** | **Application Number** EP 24 17 0236 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DONG XINZHOU ET AL: "Optimizing solution of fault location", 2002 IEEE POWER ENGINEERING SOCIETY. SUMMER MEETING. CONFERENCE PROCEEDINGS. CHICAGO, IL, JULY 21 - 25, 2002; [IEEE POWER ENGINEERING SOCIETY], NEW YORK, NY : IEEE, US, 25 July 2002 (2002-07-25), page 1113, XP031212755, ISBN: 978-0-7803-7518-5 | 1-4,9, 10,15 | INV. G01R31/08 |
| Y | * abstract * * Section: II. Assembled fault location algorithm * | 5-8, 11-14 | |
| Y | WO 2019/166903 A1 (ABB SCHWEIZ AG [CH]) 6 September 2019 (2019-09-06) * page 6, line 14 - page 9, line 9 * | 5-8, 11-14 | |
| Y | US 2020/348352 A1 (GAJARE SWAROOP [IN] ET AL) 5 November 2020 (2020-11-05) * paragraphs [0068], [0069] * | 5-8, 11-14 | |

TECHNICAL FIELDS SEARCHED (IPC)

G01R

The present search report has been drawn up for all claims

| Place of search | Date of completion of the search | Examiner |
|---|---|---|
| The Hague | 23 September 2024 | Mirkovic, Olinka |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

## ANNEX TO THE EUROPEAN SEARCH REPORT
## ON EUROPEAN PATENT APPLICATION NO.

EP 24 17 0236

This annex lists the patent family members relating to the patent documents cited in the above-mentioned European search report.
The members are as contained in the European Patent Office EDP file on
The European Patent Office is in no way liable for these particulars which are merely given for the purpose of information.

23-09-2024

| Patent document cited in search report | Publication date | Patent family member(s) | Publication date |
|---|---|---|---|
| WO 2019166903 A1 | 06-09-2019 | NONE | |
| US 2020348352 A1 | 05-11-2020 | CN 111542980 A | 14-08-2020 |
| | | EP 3732760 A1 | 04-11-2020 |
| | | US 2020348352 A1 | 05-11-2020 |
| | | WO 2019130126 A1 | 04-07-2019 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8655609 B2

- US 8990036 B1

**Non-patent literature cited in the description**

- **F. V. LOPES**. Settings-Free Traveling-Wave-Based Earth Fault Location Using Unsynchronized Two-Terminal Data. *IEEE Transactions on Power Delivery*, October 2016, vol. 31 (5), 2296-2298
- **V. LOPES** ; **K. M. DANTAS** ; **K. M. SILVA** ; **F. B. COSTA**. Accurate Two-Terminal Transmission Line Fault Location Using Traveling Waves. *IEEE Transactions on Power Delivery*, April 2018, vol. 33 (2), 873-880

- **O. D. NAIDU** ; **A. K. PRADHAN**. Model Free Traveling Wave Based Fault Location Method for Series Compensated Transmission Line. *IEEE Access*, 2020, vol. 8, 193128-193137